# EUROPEAN PATENT APPLICATION

(11) **EP 1 795 627 A1**
(43) Date of publication of application: **13.06.2007**
(21) Application number: 07000816.4
(22) Date of filing: 29.03.2004
(51) Int. Cl.: C23C 16/40, C23C 16/56, H01L 21/312, H01L 21/316

(54) **CVD method for forming a porous low dielectric constant SiOCH film**

(30) Priority: 01.04.2003 US 404190
(62) Divisional of application: 04007571.5
(71) Applicant: Air Products and Chemicals, Inc., Allentown, PA 18195-1501 (US)
(72) Inventor: Vrtis, Raymond Nicholas, Orefield PA 18069 (US); Lukas, Aaron Scott, Lansdale PA 19446 (US); O'Neill, Mark Leonard, Allentown PA 18104 (US); Vincent, Jean Louise, Bethlehem PA 18020 (US); Bitner, Mark Daniel, Nazareth PA 18064 (US); Karwacki, Eugene Joseph, Jr., Orefield PA 18069 (US); Peterson, Brian Keith, Fogelsville PA 18051 (US)
(74) Representative: Kador & Partner

(57) **Abstract**

Organosilica glass and organic polymeric films useful for electronic devices and methods for making same are disclosed herein. In one embodiment of the present invention, there is provided a method for enhancing the chemical vapor deposition of a film comprising an organic species comprising: providing a substrate within a reaction chamber; introducing into the chamber gaseous chemical reagents comprising an organic precursor having carbon and hydrogen bonds contained therein and a rate enhancer wherein the rate enhancer is at least one member selected from the group consisting of an oxygen-containing compound; a peroxide compound having the formula R¹OOR²; a peracid compound having the formula R³C(O)OC(O)R⁴; a fluorine-containing compound; and a heavy inert gas; and applying energy to the chemical reagents in the reaction chamber sufficient to induce the reaction of the reagents and deposit the film upon at least a portion of the substrate.

## Description

### BACKGROUND OF THE INVENTION

The present invention relates generally to the formation of dielectric films. More specifically, the invention relates to dielectric materials and films comprising same having a low dielectric constant and enhanced mechanical properties and methods for making same.

The electronics industry utilizes dielectric materials, for example, as insulating layers between circuits and components of integrated circuits (IC) and associated electronic devices or as premetal dielectric layers. Line dimensions are being reduced in order improve the operating speed, increase the memory storage capability, and reduce the power consumption of these devices. As the line dimensions decrease, the insulating requirements for the interlayer dielectric (ILD) become increasingly rigorous. Reducing the spacing requires a lower dielectric constant material to minimize the RC time constant, where R is the resistance of the conductive line and C is the capacitance of the insulating dielectric interlayer. C is inversely proportional to line spacing and proportional to the dielectric constant (k) of the interlayer dielectric (ILD).

A number of processes have been used for preparing low dielectric constant films. Chemical vapor depostion (CVD) and spin-on dielectric (SOD) processes are typically used to prepare thin films of insulating layers. Other hybrid processes are also known such as CVD of liquid polymer precursors and transport polymerization CVD. A wide variety of low K materials deposited by these techniques have been generally classified in categories such as purely inorganic materials, ceramic materials, silica-based materials, purely organic materials, or inorganic-organic hybrids. Likewise, a variety of processes have been used for curing these materials to decompose and/or remove volatile components and substantially crosslink the films such as heating, treating the materials with plasmas, electron beams, or UV radiation.

Conventional silica (SiO₂) chemical vapor deposition (CVD) dielectric films, produced from SiH₄ or TEOS (Si(OCH₂CH₃)₄, tetraethylorthosilicate) and O₂, have a dielectric constant k greater than 4.0. There are several ways in which industry has attempted to produce silica-based CVD films with lower dielectric constants, the most successful being the doping of the insulating silicon oxide film with organic groups providing films having dielectric constants that range from 2.7 to 3.5. This organosilica glass (referred to herein as OSG) is typically deposited as a dense film (density ~ 1.5 g/cm³) from an organosilicon precursor, such as methylsilane or siloxane, and an oxidant, such as O₂ or N₂O. As industry requirements for dielectric constant or "k" values fall below 2.7 due to higher device densities and smaller dimensions, the number of candidates of suitable low k compositions for dense films is limited.

Since the dielectric constant of air is nominally 1.0, yet another approach to reducing the dielectric constant of a material may be to introduce porosity or reducing the density of the material. A dielectric film when made porous may exhibit lower dielectric constants compared to a relatively denser film. Porosity has been introduced in low dielectric materials through a variety of different means. For example, porosity may be introduced by decomposing part of the film resulting in a film having an increased porosity and a lower density. Additional fabrication steps may be required for producing porous films that ultimately add both time and energy to the fabrication process. Minimizing the time and energy required for fabrication of these films is desirable; thus discovering materials that can be processed easily, or alternative processes that minimize processing time, is highly advantageous.

The patents and applications which are known in the field of forming porous organosilica dielectric materials by CVD methods field include: U.S. Patent No. 6,054,379 which describes the CVD deposition of a dense OSG film by the reaction of an organosilane such as methylsilane and an oxidant such as nitrous oxide (N₂O); EP 1 119 035 A2 and U.S. Patent No. 6,171,945, which describe processes for depositing OSG films from organosilicon precursors with labile groups which are attached to the silicone in the presence of an oxidant such as N₂O and optimally a peroxide, with subsequent removal of the labile group with a thermal anneal to provide porous OSG; U.S. Patent No. 6,312,793 B1 which teaches the co-deposition of a film from an organosilicon precursor and an organic compound wherein an oxidant may added to the organosilicon precursor during deposition; U.S. Patent No. 6,348,725 which discloses a method for making a dense intermetal dielectric material by the PECVD of an organosil(ox)ane that preferably contains a Si-H bond and an oxidant such as N₂O; U.S. Patent Application 2002/0142585 which teaches a PECVD process for the formation of non-porous materials from a siloxane having 2 or more silicon atoms and 4 or more methyl groups; a non-silicon containing porogen species (or an organic compound) and an oxidant; and U.S. Patent Application 2002/0172766 which discloses a process for depositing a dense OSG that contains cleavable side groups bonded to silicone that volatilize upon heating to leave pores wherein the co-reactant may comprise an oxidant.

Other patents or applications which discuss the formation of other films by CVD include: WO 03/005429 which discloses a low temperature (e.g., 30°C) PECVD method for preparing a hydrogenated silicon-oxycarbide (SiCO:H) film using a mixture of a saturated organosilicon or organosilicate compound and an unsaturated hydrocarbon having 3 or less carbons using an O₂-containing gas plasma; WO 99/27156 which teaches a PECVD method for preparing a organic polymeric film using an unsaturated aliphatic hydrocarbon monomer gas an a nonpolymerizable gas such as O₂, N₂, CO₂, CO, H₂O, and NH₃; U. S. Pat. No. 4,693,799 which teaches a low temperature (<300°C) PECVD process for producing an organic film using the an aliphatic hydrocarbon, a halogenated unsaturated hydrocarbon, or an organometallic compound and other gases such as N₂, H₂, O₂, CO, CO₂, NO, NO₂, SF₆, and F₂; U.S. Pat. No. 5,000,831 which teaches the use of organic precursors with boiling points in the range of between -50°C and +15°C for the deposition of organic hydrogenated carbon films by PECVD; and the reference H. Kobayashi et. al., J. Macromol. Sci. Chem., 1974, vol A8(8), pp 1345 which teaches the addition of CCl₂F₂ and CHCl₃ to the deposition of organic polymer films from methane will increase the deposition rate up to 50 fold.

There is a need in the art to provide a method for improving the deposition of film that comprises an organic species and optionally an organosilicon compound. There is also a need to provide a process for enhancing the deposition, particularly the PECVD deposition, of a multiphasic OSG or an organic polymeric film from an organosilicon precursor and organic precursor or an organic precursor, respectively.

All references cited herein are incorporated herein by reference in their entireties.

### BRIEF SUMMARY OF THE INVENTION

The present invention satisfies one, if not all, of the needs of the art by providing a process for forming a film such as a porous OSG film or a dense organic polymer film. Specifically, in one aspect of the present invention, there is provided a chemical vapor deposition method for producing an organosilica porous film represented by the formula SiᵥO_{w}CₓH_{y}F_{z}, where v+w+x+y+z = 100%, v is from 10 to 35 atomic%, w is from 10 to 65 atomic%, x is from 5 to 30 atomic%, y is from 10 to 50 atomic%, and z is from 0 to 15 atomic%, the method comprising: providing a substrate within a reaction chamber; introducing into the reaction chamber chemical reagents comprising an at least one organosilicon compound, an organic compound, and a rate enhancer wherein the chemical reagents are in gaseous form; applying energy to the chemical reagents in the reaction chamber sufficient to react and deposit a multiphasic film onto at least a portion of the substrate wherein the multiphasic film comprises at least one structure-forming phase and at least one pore-forming phase; and exposing the multiphasic film to an energy source for a time sufficient to substantially remove the pore-forming phase contained therein and provide the porous organosilica film comprising a plurality of pores and a dielectric constant of 2.6 or less.

In a further aspect of the present invention, there is provided a method for enhancing the chemical vapor deposition of a film comprising an organic species comprising: providing a substrate within a reaction chamber; introducing into the chamber gaseous chemical reagents comprising an organic compound having carbon and hydrogen bonds contained therein and a rate enhancer wherein the rate enhancer is at least one member selected from the group consisting of an oxygen-containing compound; a peroxide compound having the formula R¹OOR² wherein R¹ and R² are independently a hydrogen, a linear or branched alkyl group having from 1 to 6 carbon atoms, or an aryl group; a peracid compound having the formula R³C(O)OC(O)R⁴ wherein R³ and R⁴ are independently a hydrogen, a linear or branched alkyl group having from 1 to 6 carbon atoms, or an aryl group; a fluorine-containing compound; and a heavy inert gas; and applying energy to the chemical reagents in the reaction chamber sufficient to induce the reaction of the reagents and deposit the film upon at least a portion of the substrate.

In yet another aspect of the present invention, there is provided a method for forming a porous organosilica glass film comprising: providing a substrate within a reaction chamber; flowing into the reaction chamber a first chemical reagent comprising an at least one organosilicon precursor; flowing into the reaction chamber a second chemical reagent comprising an at least one organic precursor distinct from the first chemical reagent and a rate enhancer; applying energy to the first and second chemical reagents in the reaction chamber sufficient to induce the reaction of the reagents and form a multiphasic film comprising at least one structure-former phase and at least one pore-former phase onto at least a portion of the substrate; and removing substantially all of the at least one pore-former phase from the multiphasic film to provide the porous organosilica glass film.

These and other aspects of the invention will become apparent from the following detailed description.

### BRIEF DESCRIPTION OF SEVERAL VIEWS OF THE DRAWINGS

Figure 1 provides a graph of the deposition rate (nm/min) vs. the ratio of the rate enhancer N₂O to organic precursor 2,5-dimethyl-2,4-hexadiene (DMHD) present in the reactor.

Figure 2 provides a graph of the normalized deposition rate to the ratio of rate enhancer O₂ to combined organosilicon precursor diethoxymethylsilane (DEMS) and organic precursor (DMHD) present in the reactor.

Figure 3 provides the Fourier Transfor Infrared (FTIR) spectrum of the film deposited using the organosilicon precursor (DEMS) (top) and the organosilicon precursor plus rate enhancer O₂ (bottom).

Figure 4 provides the FTIR spectrum of the as-deposited multiphasic OSG films from the co-deposition of an 80:20 organic precursor alpha-terpinene: organosilicon precursor (DEMS) reaction mixture with or without the addition of the rate enhancers N₂O and SiF₄ to the reaction mixture.

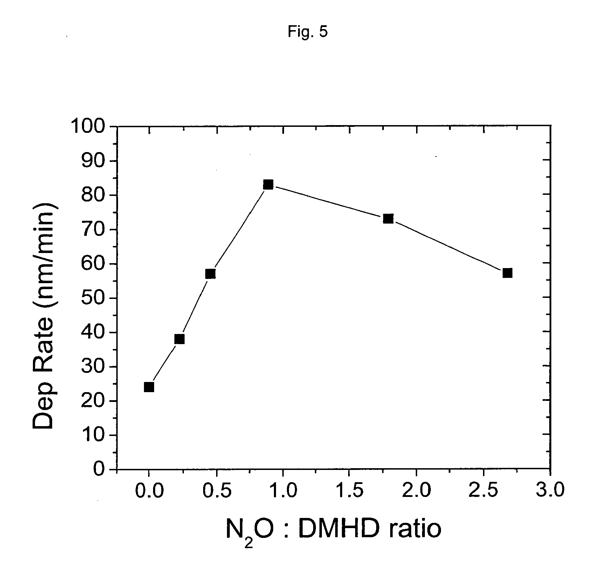

Figure 5 provides a graph of the hardness (GPa) vs. substrate temperature during the deposition of a dense OSG film deposited from diethoxymethylesilane with a CO₂ carrier gas.

### DETAILED DESCRIPTION OF THE INVENTION

The present invention is directed towards the preparation of a film having an organic species contained therein by a chemical vapor deposition process, preferably PECVD. In one embodiment of the present invention, a method is provided for preparing a porous organosilica(OSG) glass film having a low dielectric constant but sufficient mechanical properties to make the film suitable for use, for example, as an interlayer dielectric in integrated circuits. In a further embodiment of the present invention, a method is provided for preparing a dense organic polymer film. The organosilica glass film of the present invention is deposited via chemical vapor deposition of at least one organosilicon precursor selected from the group consisting of an organosilane or an organosiloxane, an organic precursor, and a rate enhancer compound. The organic polymer film of the present invention is deposited from an organic precursor and a rate enhancer. The rate enhancer may enhance the deposition rate, or in some embodiments, enable the deposition of either or both of the organosilicon precursor or the organic precursor. In certain preferred embodiments, the deposition rate of the organosilicon precursor and/or the organic precursor may be increased by at least 25%, preferably at least 50%. As a result, the amount of organic species that is deposited into the film may be also increased.

While not intending to be bound by theory, it is believed that the plasma polymerization of an organic precursor proceeds via bond dissociation in the organic precursor. This dissociation results in the formation of a hydrogen radical and a reactive organic radical. The organic radical is the active species in the deposition mechanism. The hydrogen radicals produced by this dissociation can either re-combine with the organic radical, thus terminating the deposition reaction, or combine with a second hydrogen radical to produce molecular hydrogen. Further, the presence of H₂ or hydrogen radicals in the gas phase during chemical vapor deposition may potentially decrease the deposition rate of the species. Consequently, it would be beneficial to remove the hydrogen radical and/or molecular hydrogen from the plasma. The addition of a rate enhancer such as, but not limited to, oxygen (O₂), nitrous oxide (N₂O) or silicon tetrafluoride (SiF₄) to the reaction mixture for plasma polymerized organic or organosilica films may act in removing the hydrogen radical and/or molecular hydrogen from the plasma during the chemical vapor deposition in order to enhance deposition. It is surprising and unexpected that the addition of a rate enhancer, particularly an oxygen-containing compound such as O₂ or N₂O, would enhance the deposition rate of the organic precursor because of the conventional belief that the addition of an oxygen-containing rate enhancer might be expected to react with the organic material to form water and CO₂.

The rate enhancer may also enhance the deposition of a multiphasic film from a reaction mixture comprising at least one organosilicon precursor and an organic precursor. In embodiments wherein the rate enhancer is an oxygen-containing compound, the rate enhancer may increase the deposition rate of the OSG film but does not negatively affect the dielectric constant of these films at lower levels of the rate enhancer. However, as the level of rate enhancer increases above an optimal point, the elevated levels of rate enhancer may cause negative results such as increased dielectric constant. In embodiments wherein the rate enhancer is SiF₄, the rate enhancer may not necessarily increase the deposition rate of OSG films. However, the SiF₄ rate enhancer may act differently in the plasma depending upon its co-reagent (i.e., organic precursor, organosilicon precursor, or a mixture of organic precursor and organosilicon precursor).

Other benefits may be attributable to the addition of the rate enhancer such as, but not limited to, deposition of an OSG or an organic film using higher substrate temperatures. Indeed, in some embodiments, the rate enhancer may enable the deposition of an OSG or an organic film from certain organic precursors at higher substrate temperatures that would otherwise be unattainable. In embodiments wherein an OSG film is formed via the co-deposition of at least one organosilicon precursor and organic precursor, there is minimal organic precursor deposition above a temperature of 280°C without the addition of a rate enhancer. With the rate enhancer, however, it is possible to co-deposit the multiphasic OSG films at temperatures in excess of 300°C. One added benefit of higher substrate temperatures is an improvement in the mechanical properties of the deposited films. Increased deposition temperature may correlate directly to increased mechanical strength of the post-annealed films.

The rate enhancer enables the deposition of organic polymer films from organic precursors that would would otherwise be extremely slow or unattainable. For example, the introduction of the organic compound 2,5-dimethyl-2,4-hexadiene into a RF plasma in the absence of a rate enhancer results in very slow growth of a polymer film, yet as the rate enhancer is added to the plasma, the deposition rate increases linearly. The use of the rate enhancers contained herein enhance the deposition rate thereby allowing for a greater number of precursors to be used for deposition along with greater control of final film properties.

The rate enhancer suitable for use in the method of the present invention includes oxygen-containing compounds such as oxygen (O₂), ozone (O₃), nitrous oxide (N₂O), hydrogen peroxide (H₂O₂), nitrogen dioxide (NO₂), a peroxide compound of the formula R¹OOR² wherein R¹ and R² are each independently a hydrogen atom, a linear or branched alkyl group having from 1 to 6 carbon atoms, or an aryl group; a peracid compounds having the formula R³C(O)OC(O)R⁴ wherein R³ and R⁴ are each independently a hydrogen atom, a linear or branched alkyl group having from 1 to 6 carbon atoms, or an aryl group; fluorine-containing compounds such as fluorine (F₂), silicon tetrafluoride (SiF₄), nitrogen trifluoride (NF₃), compounds of the formula CₙF₂ₙ₊₂ wherein n is a number ranging from 1 to 4, and sulfur hexafluoride (SF₆); heavy inert gases such as argon (Ar), xenon (Xe), and krypton (Kr), or mixtures thereof. In alternative embodiments, the rate enhancer compound and at least one of the organosilicon precursors may comprise the same compound. In these embodiments, the rate enhancer species may be bonded to at least one of the silicon atoms within the organosilicon precursor. Examples of such compounds include acetoxy compounds such as diacetyoxydimethylsilane, di-tert-butoxy-diacetoxysilane, etc.

The rate enhancer is a compound that may form a strong bond with hydrogen or hydrogen reaction products within the plasma that results from the deposition of the precursors. In embodiments such as those where the rate enhancer is O₂, N₂O, NO₂, F₂, NF₃, CₙF₂ₙ₊₂, SF₆, SiF₄, it is believed that the bond formed between the rate enhancer compound and the hydrogen or hydrogen by-products that is stronger than the C-H bond in the precursor or in the organic species of the as-deposited film. In other embodiments, such as those where the rate enhancer is a heavy inert gas, it is believed that an intermediate quasi-stable X-H complex is formed wherein X = Ar, Kr, or Xe and that this complex may alter the deposition pathway to enhance the deposition.

The amount or nature of the addition of the rate enhancer may vary depending upon the precursors used. The rate enhancer is preferably added as a co-reagent to the organic precursor or to a mixture comprising at least one organosilicon precursor and an organic precursor to form an organic polymeric film or a porous organosilica glass film, respectively. In certain embodiments, the rate enhancer is added as a co-reagent throughout the deposition of the film. In alternative embodiments, the rate enhancer is added as a co-reagent with the organic precursor after an initial layer of at least one organosilicon precursor has been deposited. In the latter embodiments, the deposition of the organosilicon precursor and the deposition of the organic precursor and rate enhancer may be alternated to form layers of structure-forming and pore-forming phases in the multiphasic film.

The organosilica or organic film is preferably a film that is formed onto at least a portion of a substrate. Suitable substrates that may be used include, but are not limited to, semiconductor materials such as gallium arsenide ("GaAs"), boronitride ("BN") silicon, and compositions containing silicon such as crystalline silicon, polysilicon, amorphous silicon, epitaxial silicon, silicon dioxide ("SiO₂"), silicon carbide ("SiC"), silicon oxycarbide ("SiOC"), silicon nitride ("SiN"), silicon carbonitride ("SiCN"), organosilica glasses ("OSG"), organofluorosilicate glasses ("OFSG"), fluorosilicate glasses ("FSG"), and other appropriate substrates or mixtures thereof. Substrates may further comprise a variety of layers to which the film is applied thereto such as, for example, antireflective coatings, photoresists, organic polymers, porous organic and inorganic materials, metals such as copper and aluminum, or diffusion barrier layers, e.g., TiN, Ti(C)N TaN, Ta(C)N, Ta, W, WN, TiSiN, TaSiN, SiCN, TiSiCN, TaSiCN, or W(C)N. The films of the present invention are preferably capable of adhering to at least one of the foregoing materials sufficiently to pass a conventional pull test, such as an ASTM D3359-95a tape pull test. A dense film has a density that may range from about 1.5 g/cm³ to about 2.2 g/cm³ whereas a porous film has a density less than 1.5 g/ cm³.

The organosilica or organic films of the present invention are formed onto at least a portion of a substrate from a precursor composition or mixture thereof using a variety of different methods. These methods may be used by themselves or in combination. Some examples of processes that may be used to form the multiphasic film include the following: thermal chemical vapor deposition, plasma enhanced chemical vapor deposition ("PECVD"), high density PECVD, photon assisted CVD, plasma-photon assisted ("PPECVD"), cryogenic chemical vapor deposition, chemical assisted vapor deposition, hot-filament chemical vapor deposition, CVD of a liquid polymer precursor, deposition from supercritical fluids, or transport polymerization ("TP"). U. S. Pat. Nos. 6,171,945, 6,054,206, 6,054,379, 6,159,871 and WO 99/41423 provide some exemplary CVD methods that may be used to form the film of the present invention.

In certain preferred embodiments, the organosilica or organic film is formed from a mixture of one or more gaseous chemical reagents in a chemical vapor deposition process. Although the phrase "gaseous" is sometimes used herein to describe the chemical reagents, the phrase is intended to encompass reagents delivered directly as a gas to the reactor, delivered as a vaporized liquid, a sublimed solid and/or transported by an inert carrier gas into the reactor. In addition, the reagents can be carried into the reactor separately from distinct sources or as a mixture. The reagents can be delivered to the reactor system by any number of means, preferably using a pressurizable stainless steel vessel fitted with the proper valves and fittings to allow the delivery of liquid to the process reactor.

In preferred embodiments of the present invention, the film containing an organic species, such as a porous OSG film or organic film, is formed through a PECVD process. Briefly, gaseous reagents are flowed into a reaction chamber such as a vacuum chamber and plasma energy energizes the gaseous reagents thereby forming a film on at least a portion of the substrate. In embodiments wherein a multiphasic OSG film is deposited, the multiphasic film can be formed by the co-deposition, or alternatively the sequential deposition, of a gaseous mixture comprising at least one organosilicon precursor that forms the structure-forming phase with at least one plasma-polymerizable organic precursor that forms the pore-forming phase. In embodiments wherein an organic film is deposited, the multiphasic film can be formed by the deposition of at least one plasma-polymerizable organic precursor.

Energy is applied to the gaseous reagents to induce the gases to react and to form the film on the substrate. Such energy can be provided by, e.g., thermal, plasma, pulsed plasma, helicon plasma, high density plasma, inductively coupled plasma, and remote plasma methods. A secondary rf frequency source can be used to modify the plasma characteristics at the substrate surface. Preferably, the film is formed by plasma enhanced chemical vapor deposition. It is particularly preferred to generate a capacitively coupled plasma at a frequency of 13.56 MHz. In certain embodiments, the plasma energy applied may range from 0.02 to 7 watts/cm², more preferably 0.3 to 3 watts/cm² depending upon the surface area of the substrate. Flow rates for each of the gaseous reagents including the rate enhancer may range from 10 to 5000 sccm, more preferably from 30 to 1000 sccm. Pressure values in the vacuum chamber during deposition for a PECVD process of the present invention may range from 0.01 to 600 torr, more preferably 1 to 15 torr. The temperature of the substrate during deposition may range from ambient to 450°C, preferably from 200 to 450°C, and more preferably from 300 to 450°C. It is understood however that process parameters such as plasma energy, flow rate, pressure, etc. may vary depending upon numerous factors such as the surface area of the substrate, the precursors used, the equipment used in the PECVD process, etc.

In addition to the precursor(s) that are used to form the dense organic or the OSG porous films, additional materials can be charged into the reaction chamber prior to, during and/or after the deposition reaction. Such materials include carrier gases or liquid or gaseous organic substances which (e.g.,) which may be employed in transporting the gasous phase precursors to the reaction chamber for lesser volatile precursors and/or promote the curing of the as-deposited materials and provide a more stable final film. Examples of these materials include CH₄, He, NH₃, H₂, CO, CO₂, N₂. Of the foregoing materials, CO₂ is the preferred carrier gas.

The rate of deposition of the film is preferably at least 50 nm/minute. The film is preferably deposited to a thickness of 0.002 to 10 microns, although the thickness can be varied as required. The blanket film deposited on a non-patterned surface has excellent uniformity, with a variation in thickness of less than 2% over 1 standard deviation across the substrate with a reasonable edge exclusion, wherein e.g., a 5mm outermost edge of the substrate is not included in the statistical calculation of uniformity.

In embodiments wherein a multiphasic film is deposited, the porosity of the film can be increased with the bulk density being correspondingly decreased to cause further reduction in the dielectric constant of the material and extending the applicability of this material to future generations (e.g., k < 2.0).

In certain embodiments of the present invention, the as-deposited film may be a multiphasic organosilica glass (OSG) film. These films are typically comprised of at least one-structure-former phase and at least one pore-former phase and are deposited by at least one organosilicon, or structure-former precursor, and at least one organic or pore-former precursor. The at least one pore-former phase may be dispersed within the structure-former phase. The term "dispersed" as used herein includes discrete areas of pore-former phase, air-gap (i.e., relatively large areas of pore-former phase contained within a structure-former shell), or bicontinuous areas of pore-former phase. While not intending to be bound by theory, it is believed that the porous as-deposited organosilica film, when exposed to one or more energy sources, adsorbs a certain amount of energy to enable the removal of at least a portion of the pore-former phase from the material while leaving the bonds within the structure-former phase intact. Depending upon the energy source and the chemistry of the pore-former phase, the chemical bonds within the pore-former phase may be broken thereby facilitating its removal from the material. In this manner, the pore-former phase may be partially or preferably substantially removed from the as-deposited film by exposure to at least one energy source, such as thermal or ultraviolet light sources, thereby leaving a porous OSG film that consists essentially of the structure-former phase. The resultant porous organosilica film, after exposure to one or more energy sources, will exhibit a lower density and lower dielectric constant than the as-deposited film. Examples of gaseous reagents used as structure-forming and pore-forming precursors may be found in pending U. S. Patent Applications Attorney Docket Nos. 06274PUSA, 06274P2, 06150, 06150P, 06338, and 06381 which are commonly assigned to the assignee of the present invention and incorporated herein by reference in its entirety.

The porous OSG films of the present invention comprise: (a) about 10 to about 35 atomic%, more preferably about 20 to about 30% silicon; (b) about 10 to about 65 atomic%, more preferably about 20 to about 45 atomic% oxygen; (c) about 10 to about 50 atomic%, more preferably about 15 to about 40 atomic% hydrogen; (d) about 5 to about 30 atomic%, more preferably about 5 to about 20 atomic% carbon. In certain embodiments, the porous OSG films may contain about 0.1 to about 15 atomic%, more preferably about 0.5 to about 7.0 atomic% fluorine, to improve one or more of material properties. Lesser portions of other elements such as Ge or N may also be present in certain films of the invention.

In embodiments wherein a porous OSG film is produced, a multiphasic film is deposited from at least one organosilicon precursor such as an organosilane, an organosiloxanes, or a mixture thereof and an organic precursor that acts as a pore-former or porogen. In certain embodiments of the present invention, the organosilicon precursor that acts as a structure-former and the organic precursor that acts as a pore-former are the same compound. Such compounds are referred to herein as porogenated precursors. In certain embodiments, mixtures of different organosilanes and/or organosiloxanes are used in combination. It is also within the scope of the invention to use combinations of multiple different porogens, and organosilanes and/or organosiloxanes in combination with organosilane and/or organosiloxane species with attached porogens. Such embodiments facilitate adjusting the ratio of pores to Si in the final product, and /or enhance one or more critical properties of the base OSG structure. For example, a deposition utilizing diethoxymethylsilane (DEMS) and porogen might use an additional organosilicon such as tetraethoxysilane (TEOS) to improve the film mechanical strength. A similar example may be the use of DEMS added to the reaction using the organosilicon neohexyl-diethoxymethylsilane, where the neohexyl group bound to the precursor functions as the porogen. A further example would be the addition of di-tert-butoxy-diacetoxysilane to the reaction using di-tert-butoxymethylsilane and porogen. In certain embodiments, a mixture of a first organosilicon precursor with two or fewer Si-O bonds with a second organosilicon precursor with three or more Si-O bonds, is provided to tailor a chemical composition of the inventive film. Examples of porogenated precursors that can be used in the present invention are provided in pending U. S. patent application 06274P2.

The following are non-limiting examples of organosilicon precursors suitable for use with a distinct organic precursor or pore-former precursor. In the chemical formulas which follow and in all chemical formulas throughout this document, the term "independently" should be understood to denote that the subject R group is not only independently selected relative to other R groups bearing different superscripts, but is also independently selected relative to any additional species of the same R group. For example, in the formula R¹ₙ(OR²)₄₋ₙSi, when n is 2 or 3, the two or three R¹ groups need not be identical to each other or to R².

The following are formulas representing certain organosilicon precursors suitable for use with a distinct organic compound that acts as a pore-former or porogen:

(a) the formula R¹ₙ(OR²)ₚ(O(O)CR³)₄₋₍ₙ₊ₚ₎Si where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3 and p is 0 to 3;

(b) the formula R¹ₙ(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, n+p ≤ 3 and m+q ≤ 3;

(c) the formula R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, n+p ≤ 3 and m+q ≤ 3;

(d) the formula R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R², R⁶ and R⁷ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, and n+p ≤ 3, and m+q ≤ 3;

(e) the formula (R¹ₙ(OR²)ₚ(O(O)CR³)₄₋₍ₙ₊ₚ₎Si)ₜCH₄₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3, p is 0 to 3, and t is 2 to 4, provided that n+p ≤ 4;

(f) the formula (R¹ₙ(OR²)ₚ(O(O)CR³)₄₋₍ₙ₊ₚ₎Si)ₜNH₃₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3, p is 0 to 3 and t is 1 to 3, provided that n+p ≤ 4;

(g) cyclic siloxanes of the formula (OSiR₁R₃)ₓ, where R¹ and R³ are independently H, C₁ to C₄, linear or branched, saturated, singly or multipally unsaturated, cyclic, partially or fully fluorinated, and x may be any integer from 2 to 8;

(h) cyclic silazanes of the formula (NR₁SiR₁R₃)ₓ, where R¹ and R³ are independently H, C₁ to C₄, linear or branched, saturated, singly or multipally unsaturated, cyclic, partially or fully fluorinated, and x may be any integer from 2 to 8; and

(i) cyclic carbosilanes of the formula (CR₁R₃SiR₁R₃)ₓ, where R¹ and R³are independently H, C₁ to C₄, linear or branched, saturated, singly or multipally unsaturated, cyclic, partially or fully fluorinated, and x may be any integer from 2 to 8.

The above precursors may be mixed with a organic compound that acts as a porogen or have attached porogens (i.e., porogenated precursors), and may be mixed with other molecules of these classes and/or with molecules of the same classes except where n and /or m are from 0 to 3. Examples of the latter molecules include: TEOS, triethoxysilane, di-tertiarybutoxysilane, silane, disilane, di-tertiarybutoxydiacetoxysilane, etc. Although reference is made throughout the specification to siloxanes and disiloxanes as organosilicon precursors and porogenated precursors, it should be understood that the invention is not limited thereto, and that other siloxanes, such as trisiloxanes and other linear siloxanes of even greater length, are also within the scope of the invention.

The following are non-limiting examples of organic precursor compounds suitable for use with the method and composition of the present invention. In embodiments wherein the a multiphasic OSG film is formed, the organic precursor comprises the pore-former phase or porogen whereas in embodiments wherein an organic film is formed, the organic precursor comprises the as-deposited film.

a) Cyclic hydrocarbons of the general formula CₙH₂ₙ where n = 4 - 14, where the number of carbons in the cyclic structure is between 4 and 10, and where there can be a plurality of simple or branched hydrocarbons substituted onto the cyclic structure.

### Examples include: cyclohexane, trimethylcyclohexane, 1-methyl-4(1-methylethyl)cyclohexane, cyclooctane, methylcyclooctane, etc.

b) Linear or branched, saturated, partially or multipally unsaturated hydrocarbons of the general formula CₙH_{(2n+2)-2y} where n = 2 - 20 and where y = 0 - n.

### Examples include: ethylene, propylene, acetylene, neohexane, butadiene, 2,5,-dimethyl-2,4-hexadiene, hexatriene, dimethylacetylene, neohexene, etc.

c) Singly or multipally unsaturated cyclic hydrocarbons of the general formula CₙH₂ₙ₋₂ₓ where x is the number of unsaturated sites in the molecule, n = 4 - 14, where the number of carbons in the cyclic structure is between 4 and 10, and where there can be a plurality of simple or branched hydrocarbons substituted onto the cyclic structure. The unsaturation can be located inside endocyclic or on one of the hydrocarbon substituents to the cyclic structure.

### Examples include cyclohexene, vinylcyclohexane, dimethylcyclohexene, t-butylcyclohexene, alpha-terpinene, pinene, 1,5-dimethyl-1,5-cyclooctadiene, vinyl-cyclohexene, etc.

d) Bicyclic hydrocarbons of the general formula CₙH₂ₙ₋₂ where n = 4 - 14, where the number of carbons in the bicyclic structure is between 4 and 12, and where there can be a plurality of simple or branched hydrocarbons substituted onto the cyclic structure.

### Examples include norbornane, spiro-nonane, decahydronaphthalene, etc.

e) Multipally unsaturated bicyclic hydrocarbons of the general formula CₙH₂ₙ₋₍₂₊₂ₓ₎ where x is the number of unsaturated sites in the molecule, n = 4 - 14, where the number of carbons in the bicyclic structure is between 4 and 12, and where there can be a plurality of simple or branched hydrocarbons substituted onto the cyclic structure. The unsaturation can be located inside endocyclic or on one of the hydrocarbon substituents to the cyclic structure.

### Examples include camphene, norbornene, norbornadiene, etc.

f) Tricyclic hydrocarbons of the general formula CₙH₂ₙ₋₄ where n = 4 - 14, where the number of carbons in the tricyclic structure is between 4 and 12, and where there can be a plurality of simple or branched hydrocarbons substituted onto the cyclic structure.

### Examples include adamantane.

The invention further provides compositions for conducting the inventive process. A composition of the invention for forming an OSG film preferably comprises:

(A) at least one organosilicon precursor represented by:

(a) the formula R¹ₙ(OR²)ₚ(O(O)CR³)₄₋₍ₙ₊ₚ₎Si where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3 and p is 0 to 3;

(b) the formula R¹ₙ(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m 1 1, n+p ≤ 3 and m+q≤3;

(c) the formula R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, n+p ≤ 3 and m+q≤3;

(d) the formula R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R², R⁶ and R⁷ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, and n+p ≤ 3, and m+q ≤ 3;

(e) the formula (R¹ₙ(OR²)ₚ(O(O)CR³)₄₋₍ₙ₋ₚ₎Si)ₜCH₄₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3, p is 0 to 3, and t is 2 to 4, provided that n+p ≤ 4;

(f) the formula (R¹ₙ(OR²)ₚ(O(O)CR³)₄₋₍ₙ₊ₚ₎Si)ₜNH₃₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3, p is 0 to 3 and t is 1 to 3, provided that n+p ≤ 4;

(g) cyclic siloxanes of the formula (OSiR₁R₃)ₓ, where R¹ and R³ are independently H, C₁ to C₄, linear or branched, saturated, singly or multipally unsaturated, cyclic, partially or fully fluorinated, and x may be any integer from 2 to 8;

(h) cyclic silazanes of the formula (NR₁SiR₁R₃)ₓ, where R¹ and R³are independently H, C₁ to C₄, linear or branched, saturated, singly or multipally unsaturated, cyclic, partially or fully fluorinated, and x may be any integer from 2 to 8; and

(i) cyclic carbosilanes of the formula (CR₁R₃SiR₁R₃)ₓ, where R¹ and R³ are independently H, C₁ to C₄, linear or branched, saturated, singly or multipally unsaturated, cyclic, partially or fully fluorinated, and x may be any integer from 2 to 8;, and

(B) an organic precursor distinct from the at least one organosilicon precursor, said organic precursor being at least one of:

(a) at least one cyclic hydrocarbon having a cyclic structure and the formula CₙH₂ₙ, where n is 4 to 14, a number of carbons in the cyclic structure is between 4 and 10, and the at least one cyclic hydrocarbon optionally contains a plurality of simple or branched hydrocarbons substituted onto the cyclic structure;

(b) at least one linear or branched, saturated, singly or multipally unsaturated hydrocarbon of the general formula CₙH_{(2n+2)-2y} where n = 2 - 20 and where y = 0 - n;

(c) at least one singly or multipally unsaturated cyclic hydrocarbon having a cyclic structure and the formula CₙH₂ₙ₋₂ₓ, where x is a number of unsaturated sites, n is 4 to 14, a number of carbons in the cyclic structure is between 4 and 10, and the at least one singly or multipally unsaturated cyclic hydrocarbon optionally contains a plurality of simple or branched hydrocarbons substituents substituted onto the cyclic structure, and contains endocyclic unsaturation or unsaturation on one of the hydrocarbon substituents;

(d) at least one bicyclic hydrocarbon having a bicyclic structure and the formula CₙH₂ₙ₋₂, where n is 4 to 14, a number of carbons in the bicyclic structure is from 4 to 12, and the at least one bicyclic hydrocarbon optionally contains a plurality of simple or branched hydrocarbons substituted onto the bicyclic structure;

(e) at least one multipally unsaturated bicyclic hydrocarbon having a bicyclic structure and the formula CₙH₂ₙ₋₍₂₊₂ₓ₎, where x is a number of unsaturated sites, n is 4 to 14, a number of carbons in the bicyclic structure is from 4 to 12, and the at least one multipally unsaturated bicyclic hydrocarbon optionally contains a plurality of simple or branched hydrocarbons substituents substituted onto the bicyclic structure, and contains endocyclic unsaturation or unsaturation on one of the hydrocarbon substituents; and/or

(f) at least one tricyclic hydrocarbon having a tricyclic structure and the formula CₙH₂ₙ₋₄, where n is 4 to 14, a number of carbons in the tricyclic structure is from 4 to 12, and the at least one tricyclic hydrocarbon optionally contains a plurality of simple or branched hydrocarbons substituted onto the cyclic structur;

(C) an rate enhancer compound being at least one of:

(a) an oxygen-containing compound such as oxygen (O₂), ozone (O₃), nitrous oxide (N₂O), hydrogen peroxide (H₂O₂), nitrogen dioxide (NO₂);

(b) a peroxide compound having the formula R¹OOR² wherein R¹ and R² are each independently a hydrogen atom, a linear or branched alkyl group having from 1 to 6 carbon atoms, or an aryl group;

(c) a peracid compound having the formula R³C(O)OC(O)R⁴ wherein R³ and R⁴ are each independently a hydrogen atom, a linear or branched alkyl group having from 1 to 6 carbon atoms, or an aryl group;

(d) a fluorine-containing compound such as fluorine (F₂), silicon tetrafluoride (SiF₄), nitrogen trifluoride (NF₃), compounds of the formula CₙF₂ₙ₊₂ wherein n is a number ranging from 1 to 4, and sulfur hexafluoride (SF₆); or

(e) a heavy inert gases such as argon (Ar), xenon (Xe), and krypton (Kr).

In certain embodiments of the composition, the organosilicon precursor and the rate enhancer compound comprise the same molecule. Examples of these compounds include include acetoxy compounds such as diacetyoxydimethylsilane, di-tert-butoxy-diacetoxysilane, etc. The organic precursors contained in these compositions may include any of the organic precursors described herein.

In other embodiments of the present invention, the composition to form an organic film preferably comprises at least one organic precursor which can be any of the organic precursors described herein and at least one rate enhancer compound which can be any of the rate enhancer compounds described herein.

In certain embodiments of the composition of the present invention used to form a porous OSG film, the composition preferably comprises:

(a)(i) at least one precursor selected from the group consisting of diethoxymethylsilane, dimethoxymethylsilane, di-isopropoxymethylsilane, di-t-butoxymethylsilane, methyltriethoxysilane, methyltrimethoxysilane, methyltri-isopropoxysilane, methyltri-t-butoxysilane, dimethyldimethoxysilane, dimethyldiethoxysilane, dimethyldi-isopropoxysilane, dimethyldi-t-butoxysilane, 1,3,5,7-tetramethylcyclotatrasiloxane, octamethyl-cyclotetrasiloxane and tetraethoxysilane, and (ii) a porogen distinct from the at least one precursor, said porogen being a member selected from the group consisting of alpha-terpinene, limonene, cyclohexane, 1,2,4-trimethylcyclohexane, 1,5-dimethyl-1,5-cyclooctadiene, camphene, adamantane, 1,3-butadiene, substituted dienes and decahydronaphthelene; and/or

(b)(i) at least one precursor selected from the group consisting of trimethylsilane, tetramethylsilane, diethoxymethylsilane, dimethoxymethylsilane, ditertiarybutoxymethylsilane, methyltriethoxysilane, dimethyldimethoxysilane, dimethyldiethoxysilane, methyltriacetoxysilane, methyldiacetoxysilane, methylethoxydisiloxane, tetramethylcyclotetrasiloxane, octamethylcyclotetrasiloxane, dimethyldiacetoxysilane, bis(trimethoxysilyl)methane, bis(dimethoxysilyl)methane, tetraethoxysilane and triethoxysilane, and (ii) alpha-terpinene, gamma-terpinene, limonene, dimethylhexadiene, ethylbenzene, decahydronaphthalene, 2-carene, 3-carene, vinylcyclohexene and dimethylcyclooctadiene; and

(c) at least one rate enhancer compound selected from the group consisting of an oxygen-containing compound; a peroxide compound having the formula R¹OOR² wherein R¹ and R² are independently a hydrogen, a linear or branched alkyl group having from 1 to 6 carbon atoms, or an aryl group; a peracid compound having the formula R³C(O)OC(O)R⁴ wherein R³ and R⁴ are independently a hydrogen, a linear or branched alkyl group having from 1 to 6 carbon atoms, or an aryl group; a fluorine-containing compound; a heavy inert gas

Compositions of the invention can further comprise, e.g., at least one pressurizable vessel (preferably of stainless steel) fitted with the proper valves and fittings to allow the delivery of organic precursor, optionally the organosilicon precursor, and the rate enhancer compound to the process reactor. The contents of the vessel(s) can be premixed provided that the rate enhancer compound selected will not pre-react with the organic precursor and/or the organosilicon precursor in the absence of an energy source. In an alternative embodiment, the organic precursor, the rate enhancer compound, and for porous OSG films the organosilicon precursor,can be maintained in separate vessels or in a single vessel having separation means for maintaining the porogen and precursor separate during storage. Such vessels can also have means for mixing the porogen and precursor when desired.

In certain embodiments of the present invention, such as when a multiphasic OSG film is formed, as-deposited multiphasic film is exposed to one or more energy sources to remove at least a portion, or more preferably substantially remove, the pore-forming phase and provide the porous film. Alternatively, the as-deposited multiphasic film may be exposed to a chemical treatment. The removal of substantially all porogen from the multiphasic film is assumed if there is no statistically significant measured difference in atomic composition between the annealed porous OSG and the analogous OSG without added porogen. The inherent measurement error of the analysis method for composition (e.g., X-ray photoelectron spectroscopy (XPS), Rutherford Backscattering / Hydrogen Forward Scattering (RBS/HFS)) and process variability both contribute to the range of the data. For XPS the inherent measurement error is Approx. +/- 2 atomic%, while for RBS/HFS this is expected to be larger, ranging from +/- 2 to 5 atomic% depending upon the species. The process variability will contribute a further +/-2 atomic% to the final range of the data.

The pore-forming phase is removed from the as-deposited) film by an exposing step. Other in-situ or post-deposition treatment steps, referred to herein as treating or treatment steps, may be used to enhance materials properties like hardness, stability (to shrinkage, to air exposure, to etching, to wet etching, etc.), integrability, uniformity and adhesion. Such treatments can be applied to the film prior to, during and/or after the exposure step using the same or different means as the exposure step. Thus, the term "post-treating" as used herein denotes treating the film with energy (e.g., thermal, plasma, photon, electron, microwave, etc.) or chemicals to remove porogens and, optionally, to enhance materials properties. The conditions under which the post-treating step(s) are conducted can vary greatly. For example, post-treating can be conducted under high pressure or under a vacuum ambient.

As mentioned previously, one or more energy sources may be applied to the as-deposited multiphasic film to remove at least a portion, or more preferably substantially remove, the pore-forming phase and provide the porous OSG film. The energy source for the exposing step may include, but not be limited to, a thermal source such as a hot plate, oven, furnace, or the like; in-situ or remote plasma source; an ionizing radiation source such as α-particles, β-particles, γ-rays, x-rays, high energy electron, and electron beam sources of energy; a nonionizing radiation source such as ultraviolet (10 to 400 nm), visible (400 to 750 nm), infrared (750 to 10⁵ nm), microwave (> 10⁶), and radiofrequency (> 10⁶) wavelengths of energy; or mixtures thereof. While not intending to be bound by theory, the multiphasic film may absorb the energy from the one or more energy sources which may be used to enable the removal of the pore forming phase or phases that contain bonds such as C-C, C-H, or C=C. The porous film may be substantially comprised of the remaining structure-forming phase(s) from the multiphasic film. The structure-forming phase(s) remains essentially the same, or is not chemically modified, by the exposure to the one or more energy sources. In other words, the composition of the resultant porous film may be generally the same as the composition of the structure-forming phase in the multiphasic film prior to exposure to one or more energy sources.

In certain preferred embodiments, the exposure step is conducted in a non-oxidizing atmosphere such as an inert atmosphere (e.g., nitrogen, helium, argon, etc.), a reducing atmosphere (e.g., H₂, CO), or vacuum. It is believed that the presence of oxygen during the exposure step may interfere with the removal of the pore-forming phase from the multiphasic film and substantially modify the structure forming phase(s) of the film.

In embodiments wherein the energy source comprises nonionizing radiation source, the multiphasic film may be exposed to one or more specific wavelength within the source or a broad spectrum of wavelengths. For example, the multiphasic film may be exposed to one or more particular wavelengths of light such as through a laser and/or optically focused light source. In the latter embodiments, the radiation source may be passed through optics such as lenses (e.g., convex, concave, cylindrical, elliptical, square or parabolic lenses), filters (e.g., RF filter), or windows (e.g., glass, plastic, fused silica, silicate, calcium fluoride, or magnesium fluoride windows) to provide specific and focused wavelengths of light. Alternatively, the radiation source does not pass through any optics.

Specific temperature and time durations for the exposure step may vary depending upon the chemical species used to comprise the multiphasic materials within the mixture. In certain preferred embodiments, the exposure step is conducted at a temperature below about 450°C, preferably below about 300°C, and more preferably below about 250°C. The exposure step is conducted for a time of about 60 minutes or less, preferably about 1 minute or less, and more preferably about 1 second or less. For batch processes, the time duration for the exposure step is an average of the number of wafers being treated at one time.

The exposure step may be conducted in a variety of settings depending upon the process used to form the multiphasic film. It may be advantageous for the exposure step to be conducted after or even during at least a portion of the multiphasic film formation step. The exposure step can be performed in various settings such as, but not limited to, a quartz vessel, a modified deposition chamber, a conveyor belt process system, a hot plate, a vacuum chamber, a cluster tool, a single wafer instrument, a batch processing instrument, or a rotating turnstile.

In certain preferred embodiments, the one or more energy sources comprise an ultraviolet light source. An ultraviolet light source is preferable as an energy source because the ultraviolet light source provides an insignificant heating effect, i.e., does not significantly alter the temperature of the substrate. The temperature that the substrate is subjected to during exposure to an ultraviolet light source typically ranges from between 200 to 250°C. An example of one method to remove at least a portion or substantially all of the pore-former phase from a multiphasic film is provided in pending U. S. patent application, Attorney Docket No. 06336 USA. The multiphasic film may be exposed to one or more wavelengths within the ultraviolet spectrum or one or more wavelengths within the ultraviolet spectrum such as deep ultraviolet light (i.e., wavelengths of 280 nm or below) or vacuum ultraviolet light (i.e., wavelengths of 200 nm or below).

The film of the present invention may be further subjected to post exposure, or treatment steps, such as treating the porous film with one or more second energy sources. This treatment step may be performed before, during, or after the exposing step. Preferably, the treatment step may be performed after or during at least a portion of the exposing step. The treatment step may increase the mechanical integrity of the material by, for example, promoting cross-linking within the porous film, stabilize the porous film, and/or remove additional chemical species from the network rather than forming pores. The one or more second energy sources can include any of the energy sources disclosed herein as well as chemical treatments.

The conditions under which the treatment step is conducted can vary greatly. For example, the treatment step can be conducted under high pressure or under a vacuum ambient. The environment can be inert (e.g., nitrogen, CO₂, noble gases (He, Ar, Ne, Kr, Xe), etc.), oxidizing (e.g., oxygen, air, dilute oxygen environments, enriched oxygen environments, ozone, nitrous oxide, etc.) or reducing (dilute or concentrated hydrogen, hydrocarbons (saturated, unsaturated, linear or branched, aromatics), etc.). The pressure is preferably about 1 Torr to about 1000 Torr, more preferably atmospheric pressure. However, a vacuum ambient is also possible for thermal energy sources as well as any other post-treating means. The temperature preferably ranges from 200 to 500°C, and the temperature ramp rate is from 0.1 to 100 deg °C/min. The total treatment time is preferably ranges from0.01 min to 12 hours.

In certain embodiments of the present invention, the porous film may be also subject to a chemical treatment to enhance the properties of the final material. Chemical treatment of the porous film may include, for example, the use of fluorinating (HF, SIF₄, NF₃, F₂, COF₂, CO₂F_{2,}etc.), oxidizing (H₂O₂, O₃, etc.), chemical drying, methylating, or other chemical treatments. Chemicals used in such treatments can be in solid, liquid, gaseous and/or supercritical fluid states. In certain embodiments, supercritical fluid treatment may be used to treat the film. The fluid can be carbon dioxide, water, nitrous oxide, ethylene, SF₆, and/or other types of chemicals. Other chemicals can be added to the supercritical fluid to enhance the process. The chemicals can be inert (e.g., nitrogen, CO₂, noble gases (He, Ar, Ne, Kr, Xe), etc.), oxidizing (e.g., oxygen, ozone, nitrous oxide, etc.), or reducing (e.g., dilute or concentrated hydrocarbons, hydrogen, etc.). The temperature is preferably ambient to 500°C. The chemicals can also include larger chemical species such as surfactants. The total exposure time is preferably from 0.01 min to 12 hours.

In embodiments wherein the film is subjected to a plasma, the plasma is conducted under the following conditions: the environment can be inert (nitrogen, CO₂, noble gases (He, Ar, Ne, Kr, Xe), etc.), oxidizing (e.g., oxygen, air, dilute oxygen environments, enriched oxygen environments, ozone, nitrous oxide, etc.), or reducing (e.g., dilute or concentrated hydrogen, hydrocarbons (saturated, unsaturated, linear or branched, aromatics), etc.). The plasma power is preferably 0-5000 W. The temperature preferably ranges from ambient to 500°C. The pressure preferably ranges from 10 mtorr to atmospheric pressure. The total treatment time is preferably 0.01 min to 12 hours.

Photocuring for selective removal of the pore-forming phase and/or perfecting the lattice structure of the film is conducted under the following conditions: the environment can be inert (e.g., nitrogen, CO₂, noble gases (He, Ar, Ne, Kr, Xe), etc.), or reducing (e.g., dilute or concentrated hydrocarbons, hydrogen, etc.). The temperature is preferably ambient to 500°C. The power is preferably 0 to 5000 W. The wavelength is preferably IR, visible, UV or deep UV (wavelengths < 200nm). The total curing time is preferably 0.01 min to 12 hours.

Microwave post-treatment for selective removal of the pore-forming phase and/or perfecting the lattice structure of the film is conducted under the following conditions: the environment can be inert (e.g., nitrogen, CO₂, noble gases (He, Ar, Ne, Kr, Xe), etc.), oxidizing (e.g., oxygen, air, dilute oxygen environments, enriched oxygen environments, ozone, nitrous oxide, etc.), or reducing (e.g., dilute or concentrated hydrocarbons, hydrogen, etc.). The temperature is preferably ambient to 500°C. The power and wavelengths are varied and tunable to specific bonds. The total curing time is preferably from 0.01 min to 12 hours.

Electron beam post-treatment for selective removal of pore-formers or specific chemical species from an organosilicate film and/or improvement of film properties is conducted under the following conditions: the environment can be vacuum, inert (e.g., nitrogen, CO₂, noble gases (He, Ar, Ne, Kr, Xe), etc.), oxidizing (e.g., oxygen, air, dilute oxygen environments, enriched oxygen environments, ozone, nitrous oxide, etc.), or reducing (e.g., dilute or concentrated hydrocarbons, hydrogen, etc.). The temperature is preferably ambient to 500°C. The electron density and energy can be varied and tunable to specific bonds. The total curing time is preferably from 0.001 min to 12 hours, and may be continuous or pulsed. Additional guidance regarding the general use of electron beams is available in publications such as: S. Chattopadhyay et al., Journal of Materials Science, 36 (2001) 4323-4330; G. Kloster et al., Proceedings of IITC, June 3-5, 2002, SF, CA; and U.S. Pat. Nos. 6,207,555 B1, 6,204,201 B1 and 6,132,814 A1.

The porous OSG and dense organic films of the present invention are suitable for a variety of uses. The porous OSG films are particularly suitable for deposition on a semiconductor substrate, and are particularly suitable for use as, e.g., an insulation layer, an interlayer dielectric layer and/or an intermetal dielectric layer. The films can form a conformal coating. The mechanical properties exhibited by these films make them particularly suitable for use in Al subtractive technology and Cu damascene or dual damascene technology.

The films are compatible with chemical mechanical planarization (CMP) and anisotropic etching, and are capable of adhering to a variety of materials, such as silicon, SiO₂, Si₃N₄, OSG, FSG, silicon carbide, hydrogenated silicon carbide, silicon nitride, hydrogenated silicon nitride, silicon carbonitride, hydrogenated silicon carbonitride, boronitride, antireflective coatings, photoresists, organic polymers, porous organic and inorganic materials, metals such as copper and aluminum, and diffusion barrier layers such as but not limited to TiN, Ti(C)N, TaN, Ta(C)N, Ta, W, WN or W(C)N. The films are preferably capable of adhering to at least one of the foregoing materials sufficiently to pass a conventional pull test, such as ASTM D3359-95a tape pull test. A sample is considered to have passed the test if there is no discernible removal of film.

Thus in certain embodiments, the film is an insulation layer, an interlayer dielectric layer, an intermetal dielectric layer, a capping layer, a chemical-mechanical planarization or etch stop layer, a barrier layer or an adhesion layer in an integrated circuit.

Although the invention is particularly suitable for providing films and products of the invention are largely described herein as films, the invention is not limited thereto. Products of the invention can be provided in any form capable of being deposited by CVD, such as coatings, multilaminar assemblies, and other types of objects that are not necessarily planar or thin, and a multitude of objects not necessarily used in integrated circuits. Preferably, the substrate is a semiconductor.

The invention will be illustrated in more detail with reference to the following Examples, but it should be understood that the present invention is not deemed to be limited thereto.

### EXAMPLES

Exemplary dense and porous films were formed via a plasma enhanced CVD process using an Applied Materials Precision-5000 system in a 200 mm DxZ vacuum chamber that was fitted with an Advance Energy 200 rf generator from a variety of different chemical precursors and process conditions. Unless otherwise stated, the glass films were deposited onto 8" high, low resistivity (R < 0.02 Ω·cm) silicon wafers purchased from Wafernet. The CVD process generally involved the following basic steps: initial set-up and stabilization of gas flows, deposition, and purge/evacuation of chamber prior to wafer removal. The thickness and refractive index of each film were measured on an SCI Filmtek 2000 Reflectometer. The dielectric constant of each film was determined using a mercury drop probe capacitance technique on low resistivity p-type wafers (R < 0.02 ohm-cm). Mechanical properties were determined using a MTS Nano Indenter. Transmission FTIR spectra were determined using a Thermo-Nicolet 750 Spectrophotometer at 4 cm⁻¹ resolution.

Where applicable, thermal post-treatment or annealing was performed in an Applied Test Systems, Inc. series 3210 tube furnace fitted with 4" diameter purged quartz tube with a nitrogen purge ranging from 2 to 4 slpm. The ramp rate was 13°C per minute from 25 to 425°C. At 425°C, the films were soaked for 240 minutes. The films were allowed to cool to below 100°C before removal from the furnace

### Comparative Example: Deposition of a Porous OSG Film with and without a Hydrogen Source

Two multiphasic organosilica glass (OSG) films, one deposited without a hydrogen source and one deposited with a hydrogen source (propylene) were formed onto a silicon wafer via plasma enhanced chemical vapor deposition (PECVD) of a 80:20 mixture (500 mg/mn) of the organic precursor decahydronaphthalene (DHN) to the organosilicon precursor diethoxymethylsilane (DEMS) using a carbon dioxide carrier gas. The depositions were performed at 8 torr, 600 W plasma power, and a 400 milli-inch (mils) spacing between the top electrode and the substrate. The flow rate of the carbon dioxide carrier gas was 250 sccm for the first film. The flow rate of the carbon dioxide carrier gas was 150 sccm and the flow rate of propylene was 300 sccm for the second film. The substrate temperature during the depositions was maintained at 250°C.

After 300 seconds, the thickness of the first film without the addition of propylene was 1507 nm or had a deposition rate of 301 nm/min, whereas the thickness of the second film with the addition of propylene was 776 nm or had a deposition rate of 155 nm/min. This indicates that the presence of hydrogen within the plasma may slow the deposition rate of a reaction mixture containing an organic species.

### Example 1: Deposition of an DMHD Organic Polymer Film Using Nitrous Oxide as Rate enhancer

A series of organic polymer films were formed onto a silicon wafer via plasma enhanced chemical vapor deposition (PECVD) of the organic precursor 2,5-dimethyl-2,4-hexadiene (DMHD) (1100 mg/min, 224 sccm) and carbon dioxide carrier gas (300 sccm) and various flow rates of a nitrous oxide (N₂O) rate enhancer as provided in Table I. The depositions were performed at 8 torr, 600 W plasma power, and a 300 milli-inch (mils) spacing between the top electrode and the substrate. The substrate temperature during deposition was maintained at 250°C. The deposition rate, N₂O/DMDH ratio, and refractive index for each film is provided in Table I.

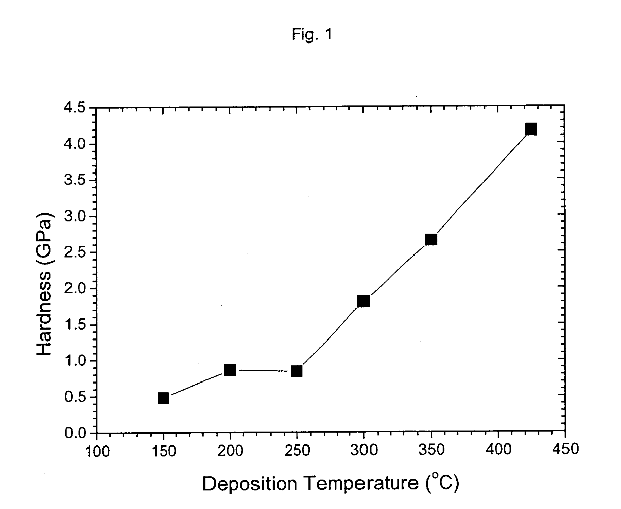

Referring to Table I and Figure 1, the deposition rate shows a linear increase with a slope -2.5 (relative to DMHD alone) as N₂O is added to the deposition. This effect saturates at a 1:1 N₂O:DMHD molar ratio. At higher N₂O concentrations, the deposition rate decreases with a slope of -0.5. This may be a result of dilution effects. It is important to note that the refractive index of the films, which corresponds to the density of bonds as well as the degree of unsaturation within the film, is independent of N₂O concentration. This suggests that the chemical structure of the material is not changing with deposition rate.

**Table I: Relationship between N₂O flow and deposition rate for thin films produced by PE-CVD of DMHD**

| N₂O Flow (sccm) | N₂O:DMHD Ratio | Deposition Rate (nm/min) | Refractive Index |
|---|---|---|---|
| 0 | 0 | 24 | 1.586 |
| 50 | 0.22 | 38 | 1.585 |
| 100 | 0.45 | 57 | 1.594 |
| 200 | 0.89 | 83 | 1.589 |
| 400 | 1.79 | 73 | 1.581 |
| 600 | 2.68 | 57 | 1.586 |

### Example 2: Deposition of an OSG Dense Film Using Nitrous Oxide as Rate enhancer

A series of dense organosilica glass (OSG) films were formed onto a silicon wafer via plasma enhanced chemical vapor deposition (PECVD) of the organosilicon precursor diethoxymethylsilane (DEMS) (1000 mg/min, 167 sccm) and carbon dioxide carrier gas (300 sccm) and various flow rates of a nitrous oxide (N₂O) rate enhancer as provided in Table II. The depositions were performed at 8 torr, 600 W plasma power, and a 300 milli-inch (mils) spacing between the top electrode and the substrate. The substrate temperature during deposition was maintained at 250°C. The deposition rate, N₂O/DEMS ratio, refractive index, and dielectric constant for each film is provided in Table II.

As Table II illustrates, the deposition rate of the organosilicon precursor may also be increased by the addition of the rate enhancer but to a lesser degree than the pore-former material. However, the change in dielectric constant also suggests that the addition of the nitrous oxide rate enhancer may also be changing the film properties substantially. Therefore, while N₂O has a beneficial effect on the deposition rate, there is a slight negative impact on the dielectric constant.

**Table II: Relationship between N₂O flow and deposition rate for thin films produced by PE-CVD of DEMS**

| N₂O Flow (sccm) | N₂O:DEMS Ratio | Deposition Rate (nm/min) | Refractive Index | Dielectric Constant |
|---|---|---|---|---|
| 0 | 0 | 760 | 1.401 | 3.03 |
| 200 | 1.20 | 1040 | 1.399 | 3.30 |

### Example 3: Deposition of an OSG Dense Film Using Nitrous Oxide or Oxygen as Rate enhancers

A series of dense organosilica glass (OSG) films were formed onto a silicon wafer via plasma enhanced chemical vapor deposition (PECVD) of the organosilicon precursor diethoxymethylsilane (DEMS) (1500 mg/min, 3200 sccm) and helium carrier gas (150 sccm) and various flow rates of a nitrous oxide (N₂O) or oxygen (02) rate enhancer as provided in Tables IIIa and IIIb. The depositions were performed at 6 torr, 700 W plasma power with a 300 milli-inch (mils) spacing between the top electrode and the substrate. The substrate temperature during deposition was maintained at 425°C. The deposition rate, N₂O/DEMS ratio, refractive index, and dielectric constant for each film are provided in Tables IIIa and IIIb.

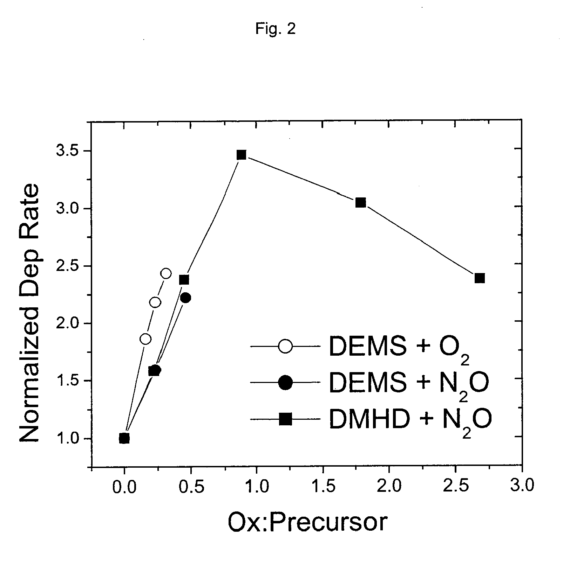

As Tables IIIa, IIIb, and Figure 2 illustrate, the data suggests that the oxygen rate enhancer may be more effective than nitrous oxide for increasing the deposition rate of DEMS. However, referring to Figure 2, the dense organosilica glass films using the oxygen rate enhancer as the co-reagent may exhibit similar deposition rate enhancement as the nitrous oxide rate enhancer did with the DMHD precursor. It is somewhat unexpected that the deposition rate of the organic precursor should be enhanced to the same degree as that of an organosilicon precursor such as DEMS. This may be coincidental. More importantly, the addition of the rate enhancer enhances the deposition rate of organic precursors without changing the refractive index of the resulting organic polymer material whereas it seems that the morphology of the OSG glass materials may change when a rate enhancer is used as a co-reagent.

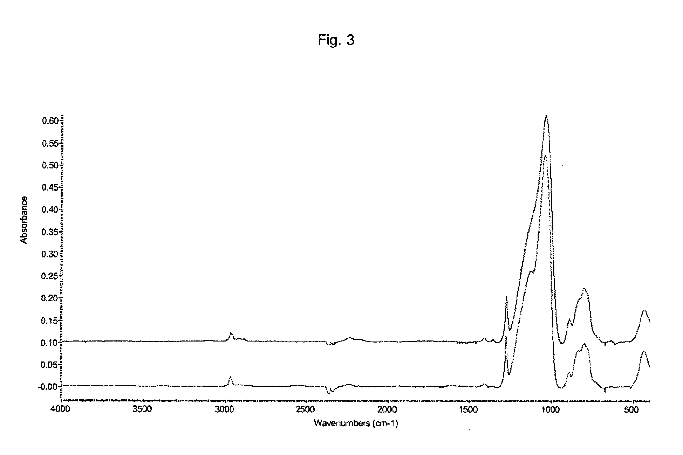

Figure 3 provides the FT-IR of a DEMS dense OSG film and a DEMS with the addition of oxygen as a rate enhancer dense OSG film (using a flow rate of 75 sccm). There are clearly differences in the Si-O stretch region, 1200-1000 cm⁻¹. While the DEMS OSG film deposited without the oxygen rate enhancer is comprised of a major peak near 1040cm⁻¹ that contains an unresolved shoulder, the film deposited with the addition of oxygen has evolved such that these peaks can be resolved from one another. Previous workers in the field have characterized these high and low energy peaks in the Si-O stretching region as arising from cage and network type structures, respectively. Further examination of these spectra requires mechanistic information regarding the deposition process.

**Table IIIa: Relationship between O₂ flow and deposition rate for thin films produced by PE-CVD of DEMS**

| O₂ Flow (sccm) | O₂:DEMS Ratio | Deposition Rate (nm/min) | Refractive Index |
|---|---|---|---|
| 0 | 0 | 515 | 1.470 |
| 50 | 0.16 | 960 | 1.442 |
| 75 | 0.23 | 1125 | 1.413 |
| 100 | 0.31 | 1250 | 1.432 |

**Table IIIb: Relationship between N₂O flow and deposition rate for thin films produced by PE-CVD of DEMS**

| N₂O Flow (sccm) | N₂O:DEMS Ratio | Deposition Rate (nm/min) | Refractive Index |
|---|---|---|---|
| 0 | 0 | 515 | 1.470 |
| 75 | 0.23 | 820 | 1.463 |
| 150 | 0.46 | 1141 | 1.449 |

### Example 4: Deposition of an OSG Porous Film Using Nitrous Oxide as Rate enhancer

A series of porous organosilica glass (OSG) films were formed onto a silicon wafer via plasma enhanced chemical vapor deposition (PECVD) of the organosilicon precursor diethoxymethylsilane (DEMS) (200 mg/min, 33 sccm), the organic precursor 2,5-dimethyl-1,5-hexadiene (DMHD) (1100 mg/min, 224 sccm), carbon dioxide carrier gas (300 sccm) and various flow rates of a nitrous oxide (N₂O) rate enhancer as provided in Table IV. The depositions were performed at 8 torr, 600 W plasma power, and a 300 milli-inch (mils) spacing between the top electrode and the substrate. The substrate temperature during deposition was maintained at 250°C. The deposition rate, refractive index, dielectric constant, and thickness loss for each film is provided in Table IV.

Table IV illustrates that the deposition of an ultralow-k porous OSG film having a k<2.0 may be enhanced by the addition of the N₂O rate enhancer. While the deposition rate increases with increasing N₂O flow, above a certain point (300 sccm N₂O) the enhanced deposition of DMHD has deleterious effects on the film properties, as evidenced by the increase in film shrinkage during thermal anneal. This may indicate that there may be too much of the pore-former phase within the film and upon removal of the pore-former phase from the film there is insufficient structure-former phase within the film to prevent it from collapsing. The increased film shrinkage may also account for the increased dielectric constant as the collapsed film may have a higher density than the non-collapsed film.

**Table IV: Film Properties of porous OSG films produced from co-deposition of DEMS and DMHD with and without the rate enhancer N₂O**

| N₂O Flow (sccm) | Deposition Rate (nm/min) | Refractive Index (as deposited) | Dielectric Constant (as deposited) | Refractive Index (post-thermal anneal) | Dielectric Constant (post-thermal anneal) | Thickness Loss during Anneal (%) |
|---|---|---|---|---|---|---|
| 0 | 85 | 1.434 | 2.89 | 1.376 | 2.78 | -4 |
| 100 | 129 | 1.455 | 2.72 | 1.455 | 2.27 | -4 |
| 200 | 169 | 1.481 | 2.79 | 1.272 | 1.98 | -6 |
| 300 | 173 | 1.489 | 2.79 | 1.264 | 1.96 | -8 |
| 400 | 194 | 1.488 | 2.85 | 1.318 | 2.03 | -24 |
| 500 | 226 | 1.490 | 2.92 | 1.286 | 2.18 | -10 |

### Example 5: Deposition of an OSG Porous Film Using Oxygen as Rate enhancer

A series of porous organosilica glass (OSG) films were formed onto a silicon wafer via plasma enhanced chemical vapor deposition (PECVD) of the organosilicon precursor diethoxymethylsilane (DEMS) (200 mg/min, 33 sccm), the organic precursor 2,5-dimethyl-1,5-hexadiene (DMHD) (1100 mg/min, 224 sccm), carbon dioxide carrier gas (300 sccm) and various flow rates of an oxygen (O₂) rate enhancer as provided in Table V. The depositions were performed at 8 torr, 600 W plasma power with a 300 milli-inch (mils) spacing between the top electrode and the substrate. The substrate temperature during deposition was maintained at 250°C. The deposition rate, refractive index, dielectric constant, and thickness loss for each film is provided in Table V.

Table V illustrates that the deposition of an low-k porous OSG films having a k<2.75 may be enhanced by the addition of the O₂ rate enhancer. Comparing the results in Tables IV and V, it appears that oxygen may be more efficient , i.e., enhances the rate using a lesser amount of chemical, than nitrous.

**Table V: Film Properties of porous OSG films produced from co-deposition of DEMS and DMHD with and without the rate enhancer 02**

| O₂ Flow (sccm) | Deposition Rate (nm/min) | Refractive Index (as deposited) | Dielectric Constant (as deposited) | Refractive Index (post-thermal anneal) | Dielectric Constant (post-thermal anneal) | Thickness Loss during Anneal (%) |
|---|---|---|---|---|---|---|
| 0 | 85 | 1.434 | 2.89 | 1.376 | 2.78 | <4 |
| 40 | 123 | 1.488 | 2.92 | 1.307 | 2.65 | <4 |

### Example 6: Deposition of an OSG Porous Film Using Oxygen as Rate enhancer

A series of porous organosilica glass (OSG) films were formed onto a silicon wafer via plasma enhanced chemical vapor deposition (PECVD) by an 80:20 mixture of an organic precursor alpha-terpinene (ATRP) (560 mg/min) to an organosilicon precursor diethoxymethylsilane (DEMS) (140 mg/min), carbon dioxide carrier gas (250 sccm) and various flow rates of a nitrous oxide or a silica tetrafluoride rate enhancer as provided in Table VI. The depositions were performed at 8 torr, 600 W plasma power with a 350 milli-inch (mils) spacing between the top electrode and the substrate. The substrate temperature during deposition is provided in Table VI. The deposition rate, refractive index, dielectric constant, and thickness loss for each film is provided in Table VI.

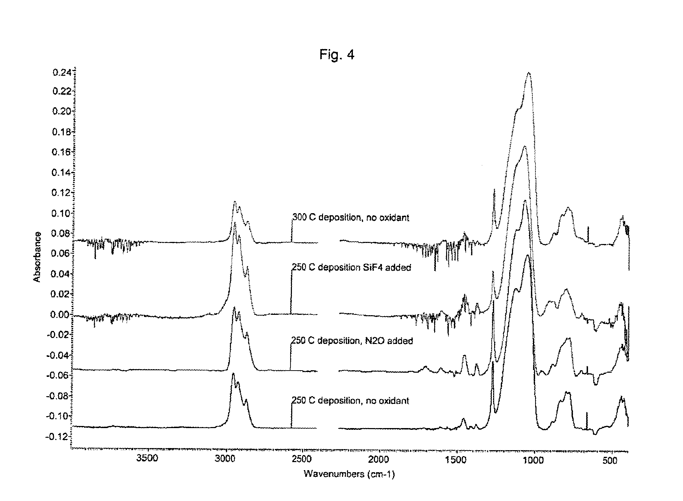

Figure 4 provides the FT-IR of the films provided in Table VI. The 2400-2300 cm⁻¹ was cleared to absorption from atmospheric CO₂. It can be seen upon review of the peak intensities in the 2900 cm⁻1 region that the addition of either N₂O or SiF₄ as rate enhancers may increase the deposition of the organic precursor relative to the organosilicon precursor or structure-forming precursor. The film deposited at 300°C shows significantly less organic precursor or pore-forming precursor incorporation relative to films deposited at 250°C.

**Table VI: Film Properties of porous OSG films produced from co-deposition of DEMS and ATRP with various rate enhancers**

| Additive (amount) | Deposition Temperature (°C) | Deposition Rate (nm/min) | Refractive Index (as deposited) | Dielectric Constant (as deposited) | Refractiv e Index (post-thermal anneal) | Dielectric Constant (post-thermal anneal) | Thickness Loss during Anneal (%) |
|---|---|---|---|---|---|---|---|
| 0 | 250 | 119 | 1.496 | 2.70 | 1.281 | 2.78 | 10 |
| N₂O (150 sccm) | 250 | 427 | 1.525 | 2.83 | 1.432 | 2.27 | 54 |
| SiF₄ (150 sccm) | 250 | 221 | 1.533 | 2.77 | 1.519 | 1.98 | 53 |
| 0 | 300 | 98 | 1.503 | 2.71 | 1.347 | 1.96 | 4 |

### Example 7: Deposition of an OSG Film Using a Organosilicon Precursor containing a Rate Enhancer

Two porous organosilica glass (OSG) films were formed onto a silicon wafer via plasma enhanced chemical vapor deposition (PECVD) by an organosilicon and organic precursor as provided in Table VII using carbon dioxide as a carrier gas. The organosilicon precursor was either diacetoxydimethylsilane which contains a rate enhance species bound to the silicon atom or diethoxymethylsilane (DEMS). The organic precursor for both films was ATRP. The depositions were performed at 8 torr, 600 W plasma power with a 400 milli-inch (mils) spacing between the top electrode and the substrate. The substrate temperature during deposition was 250°C. The precursors used, flow rate, thickness and dielectric constant for each film is provided in Table VII.

It is believed that the rate enhancer species of the organosilicon precursor, or the acetyoxy group bound to the silicon atom, releases oxygen into the plasma thereby enhancing the deposition rate. Table VII illustrates that the deposition rate of the film deposited using diacetoxydimethylsilane was significantly higher than the deposition rate of the film deposited using DEMS. Even though the flow rate for the acetoxy containing precursor was higher than the DEMS precursor, it is not high enough to account for the increased deposition rates (e.g., the molar ratio is 1.4 times the chemical flow in the film containing acetoxy but the deposition rate is 3 times higher). Further, the percentage of thickness loss during anneal was far greater than that of the DEMS-deposited film which indicates that the weight percentage of the pore-former incorporated in the as-deposited multiphasic film was higher than the DEMS deposited film.

**Table VII: Film Properties of porous OSG films produced Organosilicon Precursor having Rate Enhancer Species**

| Organo-silicon Precursor | Flow Rate of Organo silicon Precursor (sccm) | Flow Rate of Organic Precursor (ATRP) | CO2 Flow (sccm) | Ratio of Organic Precursor to Organo silicon Percursor | Deposition Rate (nm/min) | Thickness Loss during Anneal (%) | Dielectric Constant (post-thermal anneal) |
|---|---|---|---|---|---|---|---|
| Diacetoxydi methylsilane | 32 | 132 | 200 | 4.1 | 155 | 31 | 2.35 |
| DEMS | 23 | 92 | 150 | 4.0 | 58 | <3 | 2.27 |

While the invention has been described in detail and with reference to specific examples thereof, it will be apparent to one skilled in the art that various changes and modifications can be made therein without departing from the spirit and scope thereof. In the following clauses, preferred embodiments of the invention are described:
1. A chemical vapor deposition method for producing an organosilica porous film represented by the formula SiᵥO_{w}CₓH_{y}F_{z}, where v+w+x+y+z = 100%, v is from 10 to 35 atomic%, w is from 10 to 65 atomic%, x is from 5 to 30 atomic%, y is from 10 to 50 atomic%, and z is from 0 to 15 atomic%, the method comprising:
   providing a substrate within a reaction chamber;
   introducing into the reaction chamber chemical reagents comprising an at least one organosilicon precursor, an organic precursor, and a rate enhancer wherein the chemical reagents are in gaseous form;
   applying energy to the chemical reagents in the reaction chamber sufficient to react and deposit a multiphasic film onto at least a portion of the substrate wherein the multiphasic film comprises at least one structure-forming phase and at least one pore-forming phase; and
   exposing the multiphasic film to an energy source sufficient to substantially remove the pore-forming phase contained therein and provide the porous organosilica film comprising a plurality of pores and a dielectric constant of 2.6 or less.
2. The method of clause 1 further comprising treating the porous film with an at least one post-treating agent selected from the group consisting of thermal energy, plasma energy, photon energy, electron energy, microwave energy, chemicals, and mixtures thereof.
3. The method of clause 2 wherein the treating step occurs after the completion of the exposing step.
4. The method of clause 2 wherein the treating step occurs during at least a portion of the exposing step.
5. The method of clause 2 wherein the at least one post-treating agent is electron energy provided by an electron beam.
6. The method of clause 2 wherein the at least one post-treating agent is a supercritical fluid.
7. The method of clause 1 wherein the porous film has a dielectric constant of 1.9 or less.
8. The method of clause 1 wherein v is from 20 to 30 atomic%, w is from 20 to 45 atomic%, x is from 5 to 20 atomic%, y is from 15 to 40 atomic% and z is 0.
9. The method of clause 1 wherein the temperature of the applying step ranges from 25 to 450°C.
10. The method of clause 9 wherein the temperature of the applying step ranges from 200° to 450°C.
11. The method of clause 1 wherein the rate enhancer compound is at least one oxygen-containing compound selected from the group consisting of oxygen (O₂), ozone (O₃), nitrous oxide (N₂O), hydrogen peroxide (H₂O₂), nitrogen dioxide (NO₂)..
12. The method of clause 1 wherein the rate enhancer compound is at least one fluorine-containing compound selected from the group consisting of fluorine (F₂), silicon tetrafluoride (SiF₄), nitrogen trifluoride (NF₃), compounds of the formula CₙF₂ₙ₊₂ wherein n is a number ranging from 1 to 4, and sulfur hexafluoride (SF₆).
13. The method of clause 1 wherein the rate enhancer compound compound is at least one heavy inert gas selected from the group consisting of Ar, Xe, and Kr.
14. The method of clause 1 wherein the rate enhancer compound is a peroxide compound having the formula R¹OOR² wherein R¹ and R² are each independently a hydrogen atom, a linear or branched alkyl group having from 1 to 6 carbon atoms, or an aryl group.
15. The method of clause 1 wherein the rate enhancer compound is a peracid compounds having the formula R³C(O)OC(O)R⁴ wherein R³ and R⁴ are each independently a hydrogen atom, a linear or branched alkyl group having from 1 to 6 carbon atoms, or an aryl group.
16. The method of clause 1 wherein the rate enhancer and the at least one organosilicon precursor comprise the same compound.
17. The method of clause 1 wherein the at least one organosilicon precursor is represented by the formula: R¹ₙ(OR²)ₚ(O(O)CR³)₄₋₍ₙ₊ₚ₎Si where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon; R³ is independently H, C₁ to C₆ linear or branched, saturated, singly or multipally unsaturated, cyclic, aromatic, partially or fully fluorinated hydrocarbon; and wherein n is 1 to 3 and p is 0 to 3.
18. The method of clause 1 wherein the at least one organosilicon precursor is represented by the formula: R¹ₙ(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon; R⁴ and R⁵ are independently H, C₁ to C₆ linear or branched, saturated, singly or multipally unsaturated, cyclic, aromatic, partially or fully fluorinated hydrocarbon; and wherein n is 0 to 3, m is 0 to 3, q is 0 to 3 and p is 0 to 3 provided that n+m ≥ 1, n+p ≤ 3 and m+q ≤ 3.
19. The method of clause 1 wherein the at least one organosilicon precursor is represented by the formula: R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon; R⁴ and R⁵ are independently H, C₁ to C₆ linear or branched, saturated, singly or multipally unsaturated, cyclic, aromatic, partially or fully fluorinated hydrocarbon; and wherein n is 0 to 3, m is 0 to 3, q is 0 to 3 and p is 0 to 3, provided that n+m ≥ 1, n+p ≤ 3 and m+q ≤ 3.
20. The method of clause 1 wherein the at least one organosilicon precursor is represented by the formula: R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R², R⁶ and R⁷ are independently C₁ to C₆ linear or branched, saturated, singly or multipally unsaturated, cyclic, aromatic, partially or fully fluorinated hydrocarbon; R⁴ and R⁵ are independently H, C₁ to C₆ linear or branched, saturated, singly or multipally unsaturated, cyclic, aromatic, partially or fully fluorinated hydrocarbon; and wherein n is 0 to 3, m is 0 to 3, q is 0 to 3 and p is 0 to 3, provided that n+m ≥ 1, and n+p ≤ 3, and m+q ≤ 3.
21. The method of clause 1 wherein the at least one organosilicon precursor is represented by the formula: (R¹ₙ(OR²)ₚ(O(O)CR³)₄₋₍ₙ₊ₚ₎Si)ₜCH₄₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon; R³ is independently H, C₁ to C₆ linear or branched, saturated, singly or multipally unsaturated, cyclic, aromatic, partially or fully fluorinated hydrocarbon; and wherein n is 1 to 3, p is 0 to 3, and t is 2 to 4, provided that n+p≤4.
22. The method of clause 1 wherein the at least one organosilicon precursor is represented by the formula: (R¹ₙ(OR²)ₚO(O)CR³)₄₋₍ₙ₊ₚ₎Si)ₜNH₃₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon; R³ is independently H, C₁ to C₆ linear or branched, saturated, singly or multipally unsaturated, cyclic, aromatic, partially or fully fluorinated hydrocarbon; and wherein n is 1 to 3, p is 0 to 3 and t is 1 to 3, provided that n+p≤4.
23. The method of clause 1 wherein the at least one organosilicon precursor is represented by the formula: (OSiR₁R₃)ₓ, where R¹ and R³ are independently H, C₁ to C₄, linear or branched, saturated, singly or multipally unsaturated, cyclic, partially or fully fluorinated; and x may be any integer from 2 to 8.
24. The method of clause 1 wherein the at least one precursor is represented by cyclic silazanes of the formula (NR₁SiR₁R₃)ₓ, where R¹ and R³ are independently H, C₁ to C₄, linear or branched, saturated, singly or multipally unsaturated, cyclic, partially or fully fluorinated; and x may be any integer from 2 to 8.
25. The method of clause 1 wherein the at least one precursor is represented by cyclic carbosilanes of the formula (CR₁R₃SiR₁R₃)ₓ, where R¹ and R³ are independently H, C₁ to C₄, linear or branched, saturated, singly or multipally unsaturated, cyclic, partially or fully fluorinated; and x may be any integer from 2 to 8.
26. The method of clause 1 wherein the at least one organosilicon precursor is a mixture comprising a first organosilicon precursor having 2 Si-O bonds or less and a second organosilicon precursor having 3 Si-O bonds or greater.
27. The method of clause 1 wherein the at least one organosilicon precursor is a member selected from the group consisting of diethoxymethylsilane, dimethoxymethylsilane, di-isopropoxymethylsilane, di-t-butoxymethylsilane, methyltriethoxysilane, methyltrimethoxysilane, methyltri-isopropoxysilane, methyltri-t-butoxysilane, dimethyldimethoxysilane, dimethyldiethoxysilane, dimethyldi-isopropoxysilane, dimethyldi-t-butoxysilane, 1,3,5,7-tetramethylcyclotatrasiloxane, octamethyl-cyclotetrasiloxane, tetraethoxysilane, and mixtures thereof.
28. The method of clause 1 wherein the organic precursor is at least one member selected from the group represented by:
   (a) at least one cyclic hydrocarbon having a cyclic structure and the formula CₙH₂ₙ, where n is 4 to 14, a number of carbons in the cyclic structure is between 4 and 10, and the at least one cyclic hydrocarbon optionally contains a plurality of simple or branched hydrocarbons substituted onto the cyclic structure;
   (b) at least one linear or branched, saturated, partially or multipally unsaturated hydrocarbon having the formula CₙH_{(2n+2)-2y} where n = 2 - 20 and where y = 0 - n;
   (c) at least one singly or multipally unsaturated cyclic hydrocarbon having a cyclic structure and the formula CₙH₂ₙ₋₂ₓ, where x is a number of unsaturated sites, n is 4 to 14, a number of carbons in the cyclic structure is between 4 and 10, and the at least one singly or multipally unsaturated cyclic hydrocarbon optionally contains a plurality of simple or branched hydrocarbons substituents substituted onto the cyclic structure, and contains unsaturation inside endocyclic or on one of the hydrocarbon substituents;
   (d) at least one bicyclic hydrocarbon having a bicyclic structure and the formula CₙH₂ₙ₋₂, where n is 4 to 14, a number of carbons in the bicyclic structure is from 4 to 12, and the at least one bicyclic hydrocarbon optionally contains a plurality of simple or branched hydrocarbons substituted onto the bicyclic structure;
   (e) at least one multipally unsaturated bicyclic hydrocarbon having a bicyclic structure and the formula CₙH₂ₙ₋₍₂₊₂ₓ₎, where x is a number of unsaturated sites, n is 4 to 14, a number of carbons in the bicyclic structure is from 4 to 12, and the at least one multipally unsaturated bicyclic hydrocarbon optionally contains a plurality of simple or branched hydrocarbons substituents substituted onto the bicyclic structure, and contains unsaturation inside endocyclic or on one of the hydrocarbon substituents;
   (f) at least one tricyclic hydrocarbon having a tricyclic structure and the formula CₙH₂ₙ₋₄, where n is 4 to 14, a number of carbons in the tricyclic structure is from 4 to 12, and the at least one tricyclic hydrocarbon optionally contains a plurality of simple or branched hydrocarbons substituted onto the cyclic structure; and mixtures thereof.
29. The method of clause 1 wherein the organic precursor is at least one member selected from a group consisting of alpha-terpinene, limonene, cyclohexane, 1,2,4-trimethylcyclohexane, 1,5-dimethyl-1,5-cyclooctadiene, camphene, adamantane, 1,3-butadiene, substituted dienes, decahydronaphthelene, dimethylbutadiene, hexadiene, and mixtures thereof.
30. The method of clause 1 wherein the at least one organosilicon precursor and the rate enhancer comprise the same compound.
31. A method for enhancing the chemical vapor deposition of a film comprising an organic species, the method comprising:
   providing a substrate within a reaction chamber;
   introducing into the chamber gaseous chemical reagents comprising an organic precursor having carbon and hydrogen bonds contained therein and a rate enhancer compound wherein the rate enhancer is at least one member selected from the group consisting of an oxygen-containing; a peroxide compound having the formula R¹OOR² wherein R¹ and R² are independently a hydrogen, a linear or branched alkyl group having from 1 to 6 carbon atoms, or an aryl group; a peracid compound having the formula R³C(O)OC(O)R⁴ wherein R³ and R⁴ are independently a hydrogen, a linear or branched alkyl group having from 1 to 6 carbon atoms, or an aryl group; a fluorine-containing compound; and a heavy inert gaseous compound; and
   applying energy to the chemical reagents in the reaction chamber sufficient to induce the reaction of the reagents and deposit the film upon at least a portion of the substrate.
32. The method of clause 31 wherein the chemical reagents further comprises an at least one organosilicon precursor.
33. The method of clause 31 wherein the rate enhancer compound is at least one oxygen-containing compound selected from the group consisting of oxygen (O₂), ozone (O₃), nitrous oxide (N₂O), hydrogen peroxide (H₂O₂), nitrogen dioxide (NO₂)..
34. The method of clause 31 wherein the rate enhancer compound is at least one fluorine-containing compound selected from the group consisting of fluorine (F₂), silicon tetrafluoride (SiF₄), nitrogen trifluoride (NF₃), compounds of the formula CₙF₂ₙ₊₂ wherein n is a number ranging from 1 to 4, and sulfur hexafluoride (SF₆).
35. The method of clause 31 wherein the rate enhancer compound compound is at least one heavy inert gas selected from the group consisting of Ar, Xe, and Kr.
36. The method of clause 31 wherein the rate enhancer compound is a peroxide compound having the formula R¹OOR² wherein R¹ and R² are each independently a hydrogen atom, a linear or branched alkyl group having from 1 to 6 carbon atoms, or an aryl group.
37. The method of clause 31 wherein the rate enhancer compound is a peracid compounds having the formula R³C(O)OC(O)R⁴wherein R³ and R⁴ are each independently a hydrogen atom, a linear or branched alkyl group having from 1 to 6 carbon atoms, or an aryl group.
38. The method of clause 31 wherein the rate enhancer and the at least one organosilicon precursor comprise the same compound.
39. A method for forming a porous organosilica glass film, the method comprising:
   providing a substrate within a reaction chamber;
   flowing into the reaction chamber a first chemical reagent comprising an at least one organosilicon precursor;
   flowing into the reaction chamber a second chemical reagent comprising an at least one organic precursor distinct from the first chemical reagent and a rate enhancer;
   applying energy to the first and second chemical reagents in the reaction chamber sufficient to induce the reaction of the reagents and form a multiphasic film comprising at least one structure-former phase and at least one pore-former phase onto at least a portion of the substrate; and
   removing substantially all of the at least one pore-former phase from the multiphasic film to provide the porous organosilica glass film.
40. The method of clause 39 wherein the first flowing step is conducted prior to and/or during at least a portion of the second flowing step.
41. The method of clause 39 wherein the first flowing step and the second flowing step are alternated.
42. A composition comprising:
   (A) at least one organosilicon precursor selected from the group consisting of:
      (a) a compound of the formula R¹ₙ(OR²)ₚ(O(O)CR³)₄₋₍ₙ₊ₚ₎Si where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3 and p is 0 to 3;
      (b) a compound of the formula R¹ₙ(OR²)ₚ(O(O)CR⁴)₃₋ₙ₋ₚSi-O-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, n+p ≤ 3 and m+q≤3;
      (c) a compound of the formula R¹ₙ(OR²)ₚ(O(O)CR⁴)₃₋ₙ₋ₚSi-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R² and R⁶ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, n+p ≤ 3 and m+q≤3;
      (d) a compound of the formula R¹ₙ(OR²)ₚ(O(O)CR⁴)₃₋ₙ₋ₚSi-R⁷-SiR³ₘ(O(O)CR⁵)_{q}(OR⁶)_{3-m-q} where R¹ and R³ are independently H or C₁ to C₄ linear or branched, saturated, singly or multipally unsaturated, cyclic, partially or fully fluorinated hydrocarbon; R², R⁶ and R⁷ are independently C₁ to C₆ linear or branched, saturated, singly or multipally unsaturated, cyclic, aromatic, partially or fully fluorinated hydrocarbon, R⁴ and R⁵ are independently H, C₁ to C₆ linear or branched, saturated, singly or multipally unsaturated, cyclic, aromatic, partially or fully fluorinated hydrocarbon, n is 0 to 3, m is 0 to 3, q is 0 to 3 and p is 0 to 3, provided that n+m ≥ 1, and n+p ≤ 3, and m+q ≤ 3;
      (e) a compound of the formula (R¹ₙ(OR²)ₚ(O(O)CR³)₄₋₍ₙ₊ₚ₎Si)ₜCH₄₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3, p is 0 to 3, and t is 2 to 4, provided that n+p ≤ 4;
      (f) a compound of the formula (R¹ₙ(OR²)ₚ(O(O)CR³)₄₋₍ₙ₊ₚ₎Si)ₜNH₃₋ₜ where R¹ is independently H or C₁ to C₄ linear or branched, saturated, singly or multipally unsaturated, cyclic, partially or fully fluorinated hydrocarbon; R² is independently C₁ to C₆ linear or branched, saturated, singly or multipally unsaturated, cyclic, aromatic, partially or fully fluorinated hydrocarbon, R³ is independently H, C₁ to C₆ linear or branched, saturated, singly or multipally unsaturated, cyclic, aromatic, partially or fully fluorinated hydrocarbon, n is 1 to 3, p is 0 to 3 and t is 1 to 3, provided that n+p ≤ 4;
      (g) cyclic siloxanes of the formula (OSiR₁R₃)ₓ, where R¹ and R³are independently H, C₁ to C₄, linear or branched, saturated, singly or multipally unsaturated, cyclic, partially or fully fluorinated, and x may be any integer from 2 to 8;
      (h) cyclic silazanes of the formula (NR₁SiR₁R₃)ₓ, where R¹ and R³are independently H, C₁ to C₄, linear or branched, saturated, singly or multipally unsaturated, cyclic, partially or fully fluorinated, and x may be any integer from 2 to 8; and
      (i) cyclic carbosilanes of the formula (CR₁R₃SiR₁R₃)ₓ, where R¹ and R³ are independently H, C₁ to C₄, linear or branched, saturated, singly or multipally unsaturated, cyclic, partially or fully fluorinated, and x may be any integer from 2 to 8;, and
   (B) at least one organic precursor selected from the group consisting of:
      (a) at least one cyclic hydrocarbon having a cyclic structure and the formula CₙH₂ₙ, where n is 4 to 14, a number of carbons in the cyclic structure is between 4 and 10, and the at least one cyclic hydrocarbon optionally contains a plurality of simple or branched hydrocarbons substituted onto the cyclic structure;
      (b) at least one linear or branched, saturated, partially or multipally unsaturated hydrocarbon of the general formula CₙH_{(2n+2)-2y} where n = 2 - 20 and where y=O-n;
      (c) at least one singly or multipally unsaturated cyclic hydrocarbon having a cyclic structure and the formula CₙH₂ₙ₋₂ₓ, where x is a number of unsaturated sites, n is 4 to 14, a number of carbons in the cyclic structure is between 4 and 10, and the at least one singly or multipally unsaturated cyclic hydrocarbon optionally contains a plurality of simple or branched hydrocarbons substituents substituted onto the cyclic structure, and contains endocyclic unsaturation or unsaturation on one of the hydrocarbon substituents;
      (d) at least one bicyclic hydrocarbon having a bicyclic structure and the formula CₙH₂ₙ₋₂, where n is 4 to 14, a number of carbons in the bicyclic structure is from 4 to 12, and the at least one bicyclic hydrocarbon optionally contains a plurality of simple or branched hydrocarbons substituted onto the bicyclic structure;
      (e) at least one multipally unsaturated bicyclic hydrocarbon having a bicyclic structure and the formula CₙH₂ₙ₋₍₂₊₂ₓ₎, where x is a number of unsaturated sites, n is 4 to 14, a number of carbons in the bicyclic structure is from 4 to 12, and the at least one multipally unsaturated bicyclic hydrocarbon optionally contains a plurality of simple or branched hydrocarbons substituents substituted onto the bicyclic structure, and contains endocyclic unsaturation or unsaturation on one of the hydrocarbon substituents; and/or
      (f) at least one tricyclic hydrocarbon having a tricyclic structure and the formula CₙH₂ₙ₋₄, where n is 4 to 14, a number of carbons in the tricyclic structure is from 4 to 12, and the at least one tricyclic hydrocarbon optionally contains a plurality of simple or branched hydrocarbons substituted onto the cyclic structure; and
   (C) optionally a rate enhancer compound wherein the rate enhancer selected from the group consisting of:
      (a) a peroxide compound having the formula R¹OOR² wherein R¹ and R² are each independently a hydrogen atom, a linear or branched alkyl group having from 1 to 6 carbon atoms, or an aryl group;
      (b) a peracid compound having the formula R³C(O)OC(O)R⁴ wherein R³ and R⁴ are each independently a hydrogen atom, a linear or branched alkyl group having from 1 to 6 carbon atoms, or an aryl group;
      (c) a heavy inert gases such as argon (Ar), xenon (Xe), and krypton (Kr).

## Claims

1. A method for enhancing the chemical vapor deposition of a film comprising an organic species, the method comprising:
providing a substrate within a reaction chamber;
introducing into the chamber gaseous chemical reagents comprising an organic precursor having carbon and hydrogen bonds contained therein and a rate enhancer compound wherein the rate enhancer is at least one member selected from the group consisting of an oxygen-containing; a peroxide compound having the formula R¹OOR² wherein R¹ and R² are independently a hydrogen, a linear or branched alkyl group having from 1 to 6 carbon atoms, or an aryl group; a peracid compound having the formula R³C(O)OC(O)R⁴ wherein R³ and R⁴ are independently a hydrogen, a linear or branched alkyl group having from 1 to 6 carbon atoms, or an aryl group; a fluorine-containing compound; and a heavy inert gaseous compound; and
applying energy to the chemical reagents in the reaction chamber sufficient to induce the reaction of the reagents and deposit the film upon at least a portion of the substrate.

2. The method of claim 1 wherein the chemical reagents further comprises an at least one organosilicon precursor.

3. The method of claim 1 wherein the rate enhancer compound is at least one oxygen-containing compound selected from the group consisting of oxygen (O₂), ozone (O₃), nitrous oxide (N₂O), hydrogen peroxide (H₂O₂), nitrogen dioxide (NO₂)..

4. The method of claim 1 wherein the rate enhancer compound is at least one fluorine-containing compound selected from the group consisting of fluorine (F₂), silicon tetrafluoride (SiF₄), nitrogen trifluoride (NF₃), compounds of the formula CₙF₂ₙ₊₂ wherein n is a number ranging from 1 to 4, and sulfur hexafluoride (SF₆).

5. The method of claim 1 wherein the rate enhancer compound is at least one heavy inert gas selected from the group consisting of Ar, Xe, and Kr.

6. The method of claim 1 wherein the rate enhancer compound is a peroxide compound having the formula R¹OOR² wherein R¹ and R² are each independently a hydrogen atom, a linear or branched alkyl group having from 1 to 6 carbon atoms, or an aryl group.

7. The method of claim 1 wherein the rate enhancer compound is a peracid compounds having the formula R³C(O)OC(O)R⁴ wherein R³ and R⁴ are each independently a hydrogen atom, a linear or branched alkyl group having from 1 to 6 carbon atoms, or an aryl group.

8. The method of claim 1 wherein the rate enhancer and the at least one organosilicon precursor comprise the same compound.
